Europäisches Patentamt

**European Patent Office**

Office européen des brevets

(19)

(11) Veröffentlichungsnummer : **0 200 977**
**B1**

(12) **EUROPÄISCHE PATENTSCHRIFT**

(45) Veröffentlichungstag der Patentschrift :
28.03.90

(21) Anmeldenummer : 86105467.4

(22) Anmeldetag : 21.04.86

(51) Int. Cl.⁵ : **H 03 D 1/24**, G 08 G 1/09

(54) **Digitaler Demodulator.**

(30) Priorität : 07.05.85 DE 3516282

(43) Veröffentlichungstag der Anmeldung :
12.11.86 Patentblatt 86/46

(45) Bekanntmachung des Hinweises auf die Patenterteilung : 28.03.90 Patentblatt 90/13

(84) Benannte Vertragsstaaten :
AT DE FR GB IT SE

(56) Entgegenhaltungen :
DE--A-- 3 433 592
FR--A-- 2 368 826
US--A-- 4 241 451
SPECIFICATIONS OF THE RADIO DATA SYSTEM RDS FOR VHF/FM SOUND BROADCASTING, "Tech. 3244-E", März 1984, Seiten 1-59, EBU Technical Centre, Brüssel, BE;

(73) Patentinhaber : Blaupunkt-Werke GmbH
Robert-Bosch-Strasse 200
D-3200 Hildesheim (DE)

(72) Erfinder : Hegeler, Wilhelm, Dipl.-Phys.
Grosse Venedig 23
D-3200 Hildesheim (DE)

(74) Vertreter : Eilers, Norbert, Dipl.-Phys.
Blaupunkt-Werke GmbH Robert-Bosch-Strasse 200
D-3200 Hildesheim (DE)

Jouve, 18, rue St-Denis, 75001 Paris, France

**Beschreibung**

Die Erfindung betrifft einen digitalen Demodulator zur Demodulation von Eingangssignalen, die ein einen hochfrequenten Träger enthaltenden erstes amplitudenmoduliertes Signal (AM-Signal) und/oder ein zweites amplitudenmoduliertes Signal(AM-Signal) mit unterdrücktem Träger aufweisen, wobei die beiden Träger frequenzgleich und um 90° phasenverschoben sind, der im Oberbegriff des Anspruchs 1 angegebenen Gattung.

Solche digitale Demodulatoren werden für Autoradios mit und ohne Verkehrsrundfunk (VRF) — Kennung benötigt, bei welchen zusätzlich sog. RDS ; (radio-data-system) — Informationen dekodiert werden müssen. Die VRF-Kennung ist eine Schaltinformation, die von sog. VRF-Sendern ausgesendet wird. Diese Schaltinformation ist in einem amplitudenmodulierten 57 kHz-Träger enthalten, der als additiver Teil eines sog. MPX-Signals von bestimmten Rundfunksendern abgestrahlt wird. Die RDS-Informationen betreffen Senderidentifikation, Programmtyp, alternative Sendefrequenzen etc. Zur Übertragung dieser RDS-Informationen wird senderseitig eine 1,1875 kHz-Rechteckschwingung mit einer die RDS-Information kennzeichnenden Bitfolge phasenmoduliert, wobei der Wechsel der Wertigkeit eines Bit von 0 nach 1 die Phase der Rechteckschwingung um 180° verschiebt und umgekehrt. Nach Tiefpaßfilterung der phasenmodulierten Rechteckschwingung wird das so entstehende RDS-Signal einem 57 kHz-Träger aufmoduliert (Amplitudenmodulation) und gegenüber einem sog. VRF-Träger, dessen Trägerfrequenz ebenfalls 57 kHz beträgt, um 90° phasenverschoben. In dem modulierten Signal wird der 57 kHz-Träger unterdrückt und das entstehende Signal einem MPX-Signal hinzugefügt, das dann zu einem frequenzmodulierten Sendesignal verarbeitet wird. Im Empfänger des Autoradios wird von dem FM-demodulierten Signal, also dem wiedergewonnenen MPX-Signal der additive Teil als Eingangssignal dem digitalen Demodulator zugeführt, der aus diesem Eingangssignal sowohl die VRF-Kennung als auch die RDS-Information — wenn jeweils vorhanden — rückgewinnt.

Bei einem bereits vorgeschlagenen digitalen Demodulator zur Demodulation des AM-Signals mit unterdrücktem Träger ist der Analog-Digital-Wandler, im folgenden A/D-Wandler genannt, als Deltamodulator ausgebildet, dem das Eingangssignal zugeführt wird. Das deltamodulierte Eingangssignal wird mit einem Hilfssignal gemischt und einer Tiefpaßfilterschaltung zugeführt. Der Mischer besteht aus zwei Exclusiv-Oder-Glieder, im folgenden EX/OR-Glieder genannt, wobei das dem einen Eingang des einen EX/OR-Gliedes zugeführte Hilfssignal um 90° phasenverschoben ist. Die Tiefpaßfilterschaltung besteht hier aus zwei Zählern, die über eine dem Dreifachen der Periode des Trägers entsprechende Zählperiode die Eingangswerte aufintegrieren. An dem ersten Zähler ist das demodulierte AM-Signal, also das Modulationssignal oder RDS-Signal abnehmbar. Am zweiten Zähler ist ein demgegenber um 90° phasenverschobenes Signal abnehmbar, dessen höchstwertiges Bit unmittelbar das Synchronisiersignal für den Frequenzgenerator bildet. Damit die PLL auf das trägerlose AM-Signal einrasten kann, wird im Mischer das Hilfssignal mit dem Signum des Modulationssignals, also des RDS-Signals, multipliziert, und zwar beschränkt auf denjenigen Verarbeitungspfad, der dem zweiten Zähler vorgeschaltet ist. (Siehe das Dokument DE-A-3 433 592 (veröffentlicht am 20.3.86)).

Bei vorhandenem VRF-57 kHz-Träger kann dieser digitale Demodulator auch auf den VRF-Träger einrasten, wobei das Einrasten seiner PLL auf das trägerlose Signal mit der RDS-Information oder auf den VRF-Träger rein zufällig ist. ist der Demodulator jedoch auf das trägerlose Signal eingerastet, so kann die VRF-Kennung nicht demoduliert werden und tritt als Störung auf.

Der Erfindung liegt die Aufgabe zugrunde, einen Demodulator der eingangs genannten Art zu schaffen, der sowohl ein AM-Signal mit vorhandenem Träger als auch ein AM-Signal mit unterdrücktem Träger demoduliert und als weitgehend monolithisch integrierbare Schaltung ausgeführt werden kann.

Die Aufgabe ist bei einem Demodulator der im Oberbegriff des Anspruchs 1 angegebenen Gattung erfindungsgemäß durch die Merkmale im Kennzeichenteil des Anspruchs 1 gelöst.

Der erfindungsgemäße Demodulator hat den Vorteil, daß seine PLL bei vorhandenem VRF-Träger immer auf diesen einrastet. Nur bei fehlendem VRF-Träger rastet die PLL auf das AM-Signal mit unterdrücktem Träger ein. In allen Fällen wird die RDS-Information weitgehend störungsfrei rückgewonnen. Bei vorhandenem VRF-Träger wird auch die VRF-Kennung zuverlässig ermittelt.

Vorteilhafte Ausführungsformen des erfindungsgemäßen Demodulators ergeben sich aus den weiteren Ansprüchen.

Die Erfindung ist anhand von in der Zeichnung dargestellen Ausführungsbeispielen eines digitalen Demodulators im folgenden näher beschrieben. Es zeigen :

Fig. 1 ein Blockschaltbild eines digitalen Demodulators zur Demodulation des additiven Teils eines FM-demodulierten MPX-Signals,

Fig. 2 ein Schaltbild einer Taktanpaßschaltung im Demodulator gemäß Fig. 1,

Fig. 3 ein Schaltbild eines VRF-Detektors im Demodulator gemäß Fig. 1,

Fig. 4 ein Schaltbild der Addierwerke im Demodulator gemäß Fig. 1,

Fig. 5 ein Schaltbild eines Phasendemodulators im Demodulator gemäß Fig. 1,

Fig. 6 ein Blockschaltbild eines Demodulators wie in Fig. 1 gemäß einem weiteren Ausführungsbeispiel, ausschnittweise,

Fig. 7 ein Blockschaltbild eines Demodulators wie in Fig. 1 gemäß einem dritten Ausführungsbeispiel, ausschnittweise.

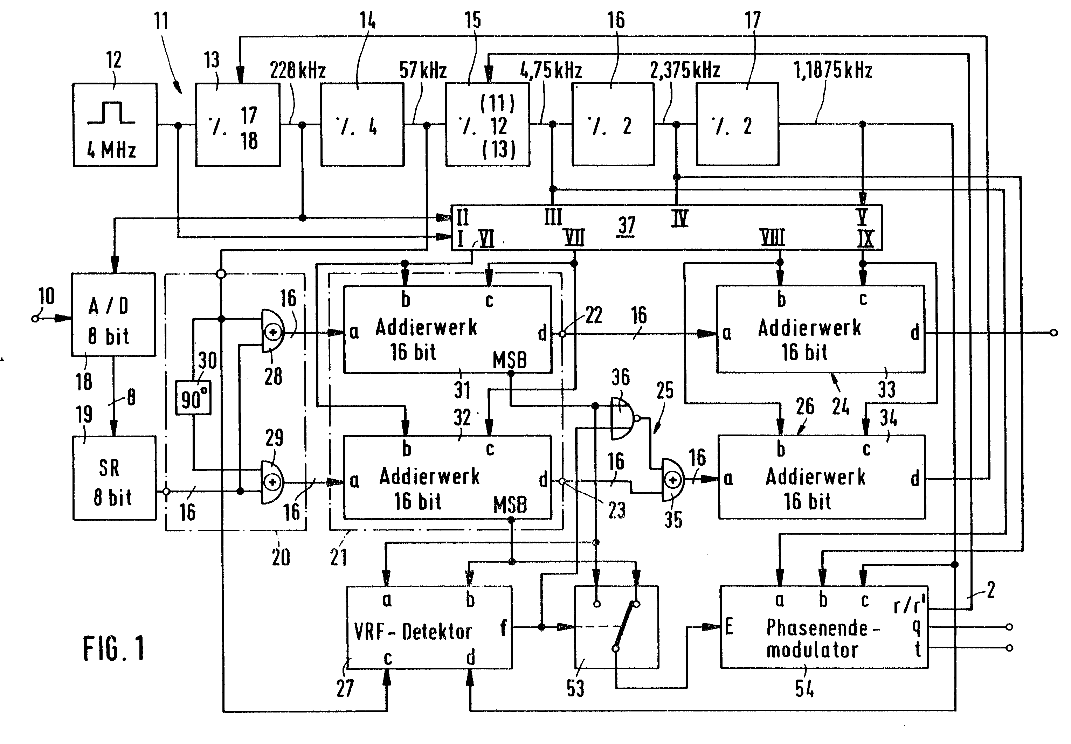

Der in Fig. 1 im Blockschaltbild dargestellte digitale Demodulator dient zur Demodulation von Eingangssignalen, die ein einen hochfrequenten Träger enthaltendes erstes amplitudenmoduliertes Signal, im folgenden AM-Signal genannt, und/oder ein zweites AM-Signal mit unterdrücktem Träger aufweisen, wobei die beiden Träger frequenzgleich und um 90˚ gegeneinander phasenverschoben sind. Wie eingangs bereits dargelegt, enthält das erste AM-Signal als Modulationssignal das sog. VRF-Signal und das zweite AM-Signal als Modulationssignal das sog. RDS-Signal. Die Frequenz des VRF-Trägers beträgt ebenso wie die Frequenz des unterdrückten RDS-Trägers 57 kHz. Beide AM-Signale sind als additiver Teil in einem sog. MPX-Signal enthalten, das als frequenzmoduliertes Sendesignal von dem Empfänger empfangen wird. Ist der Sender kein Verkehrsrundfunksender, so fehlt in dem MPX-Signal das erste AM-Signal und lediglich das zweite AM-Signal mit unterdrücktem Träger ist vorhanden. Nach FM-Demodulation wird der additive Teil des MPX-Signals über ein Bandpaßfilter dem Eingang 10 des Demodulators zugeführt.

Der Demodulator weist einen Frequenzgenerator 11 auf, der aus einem 4 MHz-Rechteckgenerator 12 und mehreren in Reihe geschalteten Frequenzteilern besteht. Der dem Rechteckgenerator 12 unmittelbar nachgeschaltete Frequenzteiler 13 weist ein steuerbares Teilerverhältnis auf, das je nach Eingangssignal an seinem Steuereingang von 17 auf 18 umschaltbar ist und umgekehrt. Am Ausgang dieses Frequenzteilers 13 steht damit im Mittel eine 228 kHz-Rechteckimpulsfolge zur Verfügung. Der nachfolgende Frequenzteiler 14 hat das konstante Teilerverhältnis 4, so daß an seinem Ausgang eine 57 kHz-Rechteckimpulsfolge abnehmbar ist. Der nachfolgende Frequenzteiler 15 hat wiederum ein steuerbares Teilerverhältnis, das je nach Steuersignal von 12 auf 11 oder 13 und umgekehrt umschaltbar ist. Am Ausgang dieses Frequenzteilers 15 ist eine 4,75 kHz-Rechteckimpulsfolge abnehmbar. Die beiden nachfolgenden Frequenzteiler 16 und 17 besitzen jeweils das Teilerverhältnis 2, so daß an ihren Ausgängen eine 2.375 kHz- bzw. 1.1875 kHz-Rechteckimpulsfolge ansteht.

An dem Eingang 10 des Demodulators ist der Eingang eines 8 Bit-Analog-Digital-Wandlers 18, im folgenden A/D-Wandler 18 genannt, angeschlossen, der mit der 228 kHz-Rechteckimpulsfolge getaktet wird. Die Digitalwerte werden einem seriellen Schieberegister 19 zugeführt. Vom Schieberegister 19 werden die Digitalwerte Bit für Bit einem Mischer 20 zugeführt, wobei nach jeweils 8 Bitwerten des A/D-Wandlers 18 weitere acht Nullen hinzugefügt werden, so daß am Eingang des Mischers 20 ein 16 Bit-Wort seriell ansteht. Dem Mischer 20 ist außerdem ein trägerfrequentes Hilfssignal zugeführt, das hier von der 57 kHz-Rechteckimpulsfolge des Frequenzgenerators 11 repräsentiert wird. Dem Mischer 20 ist eine Tiefpaßfilterschaltung 21 nachgeschaltet, deren Ausgangssignal in Sinus- und Kosinuskomponente getrennt an einem ersten Ausgang 22 als erstes Ausgangssignal und an einem zweiten Ausgang 23 als zweites Ausgangssignal abnehmbar ist. An dem ersten Ausgang 22 ist ein erster Tiefpaß 24 und an dem zweiten Ausgang 23 ist unter Zwischenschaltung eines Multiplizierers 25 ein zweiter Tiefpaß 26 angeschlossen. Der Ausgang d des zweitei Tiefpasses 26 ist unter Zwischenschaltung einer hier nicht dargestellten Logik mit dem Steuereingang des ersten Frequenzteilers 13 verbunden. Im Multiplizierer 25 findet eine Multiplikation des zweiten Ausgangssignals der Tiefpaßfilterschaltung 21 mit dem Signum des ersten Ausgangssignals der Tiefpaßfilterschaltung 21 statt, die jedoch von einem VRF-Detektor 27 dann blockiert werden kann, wenn das VRF-Signal im MPX-Signal vorhanden ist. Die Tiefpaßfilterschaltung 21 weist eine Ausgangsdatenrate auf, die einem geradzahligen Vielfachen der Modulationsfrequenz des zweiten AM-Signals, also der Frequenz des RDS-Signals, entspricht und mindestens gleich dem Vierfachen dieser Modulationsfrequenz und höchstens gleich der Trägerfrequenz 57 kHz der ersten AM-Signals bemessen ist. Im Beispiel ist die Ausgangsdatenrate der Tiefpaßfilterschaltung 21 zu 4,75 kHz gewählt. Die Ausgangsdatenrate der beiden Tiefpässe 24, 26 ist gleich der Modulationsfrequenz des zweiten AM-Signals, also 1,1875 kHz bemessen. Am Ausgang d des ersten Tiefpasses 24 ist das im ersten AM-Signal enthaltene Modulationssignal, also das VRF-Signal abnehmbar.

Im einzelnen weist in dem Ausführungsbeispiel des Demodulators nach Fig. 1 der Mischer 20 zwei Exclusiv-Oder-Glieder 28, 29 auf, im folgenden kurz EX/OR-Glieder 28, 29 genannt. Jeweils ein Eingang der beiden EX/OR-Glieder 28, 29 ist mit dem Ausgang des seriellen Schieberegisters 19 verbunden. Der andere Ausgang des EX/OR-Gliedes 28 ist mit der 57 kHz-Rechteckimpulsfolge und der andere Eingang des EX/OR-Gliedes 29 mit der um 90˚ phasenverschobenen Rechteckimpulsfolge belegt, wozu hier in der Verbindungsleitung vom Ausgang des Frequenzteilers 14 zum Eingang des EX/OR-Gliedes 29 ein 90˚-Phasenschieber 30 dargestellt ist. In der Praxis wird dieser Phasenschieber jedoch nicht zu finden sein, da üblicherweise die Frequenzteiler so aufgebaut sind, daß bei einem Teilerverhältnis von 1 : 4 alle vier Phasen also 0, ± 90˚, 180˚ zur Verfügung stehen.

Die Tiefpaßfilterschaltung 21 weist zwei serielle Addierwerke 31, 32 auf, wobei der Eingang a des ersten Addierwerkes 31 mit dem Ausgang des EX/OR-Gliedes 28 und der Eingang a des zweiten Addierwerkes 32 mit dem Ausgang des EX/OR-Gliedes 29 verbunden ist. Die weiteren Eingänge b und c der beiden Addierwerke 31, 32 sind mit einer Taktanpaßschaltung 37 verbunden, die wiederum an einigen Ausgängen des Frequenzgenerators 11 angeschlossen ist.

Die beiden Tiefpässe 24, 26 sind in Fig. 1 ebenfalls als serielle Addierwerke 33, 34 ausgebildet, wobei der Eingang a des dritten Addierwerkes 33 unmittelbar mit dem Ausgang d des ersten Addierwerkes 31 verbunden ist, während der Eingang a des vierten Addierwerkes 34 über den Multiplizierer 25 an dem Ausgang d des zweiten Addierwerkes 32 angeschlossen ist. Der Multiplizierer 25 weist hier ein EX/OR-Glied 35 und ein NOR-Glied 36 auf. Der Ausgang des EX/OR-Gliedes 35 ist mit dem Eingang a des vierten Addierwerkes 34 verbunden. Der eine Eingang des EX/OR-Gliedes 35 liegt an dem Ausgang d des zweiten Addierwerkes 32 und der andere Eingang an dem Ausgang des NOR-Gliedes 36. Von den beiden Eingängen des NOR-Gliedes 36 liegt der eine an dem Ausgang f des VRF-Detektors 27 und der andere an einem Teilausgang des ersten Addierwerkes 31, der das höchstwertige Bit (MSB) der ersten Ausgangssignals führt.

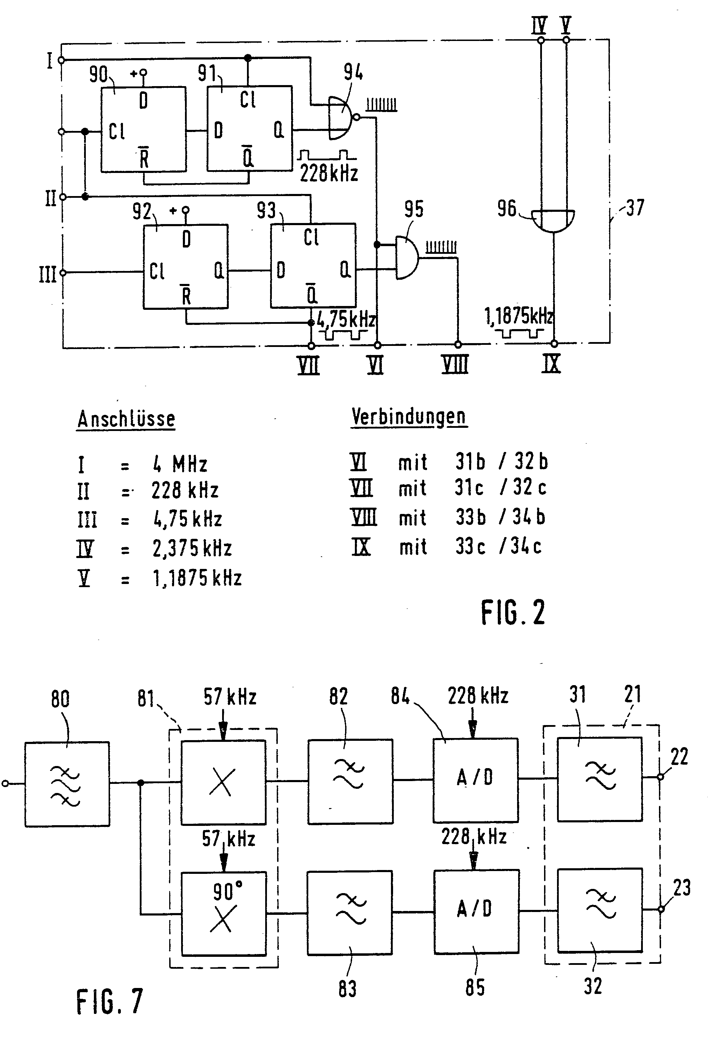

Der Aufbau der Taktanpaßschaltung 37 ist in Fig. 2 im einzelnen dargestellt. Der Übersichtlichkeit halber ist die Frequenzbelegung der Anschlüsse I-V und die Verbindungen der Ausgänge VI-IX der Taktanpaßschaltung 37 mit anderen Bauelementen in Fig. 1 in Fig. 2 aufgelistet.

Durch die logische Verknüpfung der Logikelemente, wie D-Flip-Flops 90, 91, 92, 93, NOR-Gatter 94, AND-Gatter 95 und OR-Gatter 96 untereinander und mit den Eingängen I-V der Taktanpaßschaltung 37 wird erreicht, daß an dem Ausgang VI ein Bündel von sechzehn 4 MHz-Impulsen mit einer Wiederholfrequenz von 228 kHz, an dem Ausgang VIII ein gleiches Bündel von sechzehn Impulsen mit einer Wiederholfrequenz von 4,75 kHz, am Ausgang VII eine invertierte 4,75 kHz-Rechteckimpulsfolge mit einem Tastverhältnis von 1 : 48 und an dem Ausgang IX eine invertierte 1,1875 kHz-Rechteckimpulsfolge mit einem Tastverhältnis von 1 : 4 liegt. Hierzu wird mit den D-Flip-Flops 90, 91 eine 228 kHz-Rechteckimpulsfolge mit einem Testverhältnis von 1 : 17,5 generiert, die mit der 228 kHz-Rechteckimpulsfolge durch das NOR-Gatter 94 verknüpft wird. Die Reihenschaltung der D-Flip-Flops 92, 93 generiert eine 4,75 kHz-Rechteckimpulsfolge mit einem Tastverhältnis von 1 : 48, die mit dem Ausgang des NOR-Gatters 94 durch das AND-Gatter 95 verknüpft ist. Die invertierte Rechteckimpulsfolge am Ausgang VII wird von dem $\overline{Q}$-Ausgang des D-Flip-Flops 95 abgenommen, während die invertierte Rechteckimpulsfolge am Ausgang IX durch ODER-Verknüpfung der 2,375 kHz- und 1,1875 kHz-Rechteckimpulsfolgen im OR-Gatter 96 gewonnen wird.

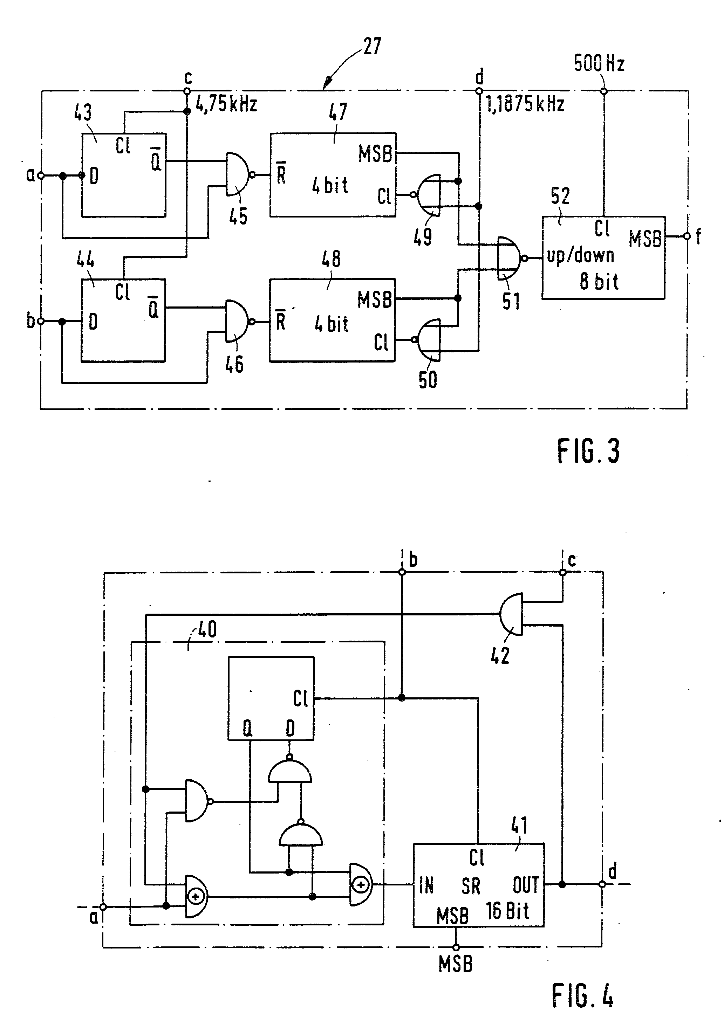

Der Aufbau der Addierwerke 31-34 ist identisch und in Fig. 4 dargestellt. Die Addierwerke 31 und 32 unterscheiden sich von den Addierwerken 33 und 34 lediglich durch die Taktbelegung der Eingänge b und c, wie vorstehend beschrieben. Jedes Addierwerk 31-34 weist einen seriellen 1 Bit-Addierer 40 und ein diesem nachgeschaltetes serielles 16 Bit-Schieberegister 41 auf, dessen Ausgang über ein als Torglied wirkendes AND-Glied 42 auf den Eingang des Addierers 40 rückgeführt ist. Der andere Eingang des AND-Gliedes 42 ist mit dem Eingang c des Addierwerkes 31-34 verbunden. Die Takteingänge C1 des Addierers 40 und des Schieberegisters 41 sind mit dem Eingang b des jeweiligen Addierwerkes 31-34 verbunden. Die Feinstruktur des 1 Bit-Addierers 40 ist aus Fig. 4 ohne weiteres ersichtlich. Im dem Addierer 40 wird das am Eingang a anliegende 16 Bit-Wort Bit für Bit zu dem Inhalt des Schieberegisters 41 aufaddiert. Dies geht bei den Addierwerken 31 und 32 über zwölf Perioden von 57 kHz (eine Periode von 4,75 kHz), d. h. 48 16 Bit-Worte oder Samples vom Mischer 20 werden aufaddiert (vergl. Impulsbündel am Ausgang VI der Tastanpaßschaltung 37). Danach ist für eine Periode von 228 kHz der Eingang c der Addierwerke 31, 32 logisch 0 (vergl. 4,75 kHz-Rechteckimpulsfolge mit unsymmetrischen Tastverhältnis am Ausgang VII der Taktanpaßschaltung 37), so daß nur die am Eingang a erscheinenden Bitwerte in das Schieberegister 41 eingeschrieben werden. Das Schieberegister 41 wird damit zurückgesetzt. Gleichzeitig werden die am Ausgang d erscheinenden, zuvor im Schieberegister 41 abgespeicherten Bitwerte jeweils in die Addierwerke 33, 34 übernommen. Hierzu erhält der Eingang b dieser Addierwerke 33, 34 von dem Ausgang VIII der Taktanpaßschaltung 37 ein Bündel von 16 Impulsen, aber nur dann, wenn der Eingang c der Addierwerke 31, 32 Null ist. In den Addierwerken 33 und 34 werden zunächst vier der von den Addierwerken 31 bzw. 32 übernommenen 16 Bit-Worte aufaddiert. Nach jeder vierten dieser Addition — also im Takt von 1,1875 kHz — wird der Eingang c der beiden Addierwerke 33, 34 für eine 4,75-kHz-periode Null (vergl. 1,1875 kHz-Rechteckimpulsfolge mit unsymmetrischen Tastverhältnis am Ausgang IX der Taktanpaßschaltung 37). In dieser Zeit werden die Schieberegister 41 der beiden Addierwerke 33, 34 ausgewertet.

Die PLL des Demodulators soll bei vorhandenem VRF-Sigal auf dessen Träger einrasten und muß bei fehlendem VRF-Signal auf das zweite AM-Signal mit unterdrücktem Träger einrasten können. Hierzu wird bei fehlendem VRF-Signal das 16 Bit-Ausgangssignal des Addierwerkes 32 mit dem Signum des 16 Bit-Ausgangssignals des Addierwerkes 31 multipliziert. Dieses Signum wird von dem MSB des 16 Bit-Ausgangssignals repräsentiert, so daß der eine Eingang des EX/OR-Gliedes 35 über das NOR-Glied 36 mit dem dieses höchstwertige Bit führenden Teilausgang des Addierwerkes 31 verbunden ist. Bei vorhandenem VRF-Signal muß diese Signummultiplikation unterdrückt werden, damit die PLL auf den VRF-Träger einrastet. Diese Aufgabe übernimmt der VRF-Detektor 27.

Der Aufbau des VRF-Detektors 27 ist in Fig. 3 im einzelnen dargestellt. Prinzipiell arbeitet der VRF-Detector 27 in der Weise, daß er die Ausgangssignale der Tiefpaßfilterschaltung 21, hier also die Ausgangssignale der beiden Addierwerke 31 und 32, auf Konstanz ihrer Polarität prüft und dann ein für das Vorhandensein des VRF-Signals charakteristisches Ausgangssignal abgibt, wenn mindestens eines der beiden Ausgangssignale der Tiefpaßfilterschaltung 21 über eine vorgegebene Zeitdauer konstante Polarität aufweist. Hierzu sind die beiden Detektoreingänge a und b jeweils an die Ausgänge der Addierwerke 31, 32 angeschlossen, und zwar mit demjenigen Teilausgang, der das höchstwertige Bit führt. Jedem Detektoreingang a bzw. b ist ein D-Flip-Flop 43 bzw. 44, ein NAND-Glied 45 bzw. 46 und ein 4 Bit-Zähler 47 bzw. 48 zugeordnet, wobei jeweils der D-Eingang des D-Flip-Flops 43 bzw. 44 und der eine Eingang des NAND-Gliedes 45 bzw. 46 mit dem Detektoreingang a bzw. b, der andere Eingang des NAND-Gliedes 45 bzw. 46 mit dem $\overline{Q}$-Eingang des D-Flip-Flops 43 bzw. 44 und der Ausgang des D-Flip-Flops 45

4

bzw. 46 mit dem negierten Reset-Eingang des 4 Bit-Zählers 47 bzw. 48 verbunden ist. Der Takteingang der beiden 4 Bit-Zähler 47, 48 liegt über jeweils ein NOR-Glied 49 bzw. 50 an dem 1,1875 kHz-Ausgang des Frequenzgenerators 11, während jeweils der andere Eingang der NOR-Glieder 49, 50 mit dem MSB-Ausgang des zugeordneten 4 Bit-Zählers 47 bzw. 48 verbunden ist. Die MSB-Ausgänge der beiden 4 Bit-Zähler 47, 48 sind über ein weiteres NOR-Glied 51 mit dem Zähleingang up/down eines 8 Bit-up/down-Zählers 52 verbunden, an dessen Takteingang CI eine Rechteckimpulsfolge von ca. 500 Hz liegt, die z. B. aus der 1,1875 kHz-Rechteckimpulsfolge durch entsprechende Frequenzteilung (z. B. durch den Teiler 2) gewonnen werden kann. Der MSB-Ausgang des up/down-Zählers 52 bildet den Ausgang f des VRF-Detektors 27, der mit dem Multiplizierer 25 verbunden ist.

Bei Anwesenheit des VRF-Signals hat ein Ausganssignal der Addierwerke 31 und 32 ein konstantes Vorzeichen, wobei das Ausgangssignal des Addierwerkes 32 dann konstant ist, wenn die PLL auf das zweite AM-Signal mit unterdrücktem Träger eingerastet ist. Der letztere Zustand ist jedoch unerwünscht. Ist das Vorzeichen konstant, so treten an den Detektoreingängen a und b keine Flanken auf. Sind die Vorzeichen jedoch nicht konstant, so setzen die Flanken an den Eingängen a und b die 4 Bit-Zähler 47, 48 zurück. Bei konstantem Vorzeichen eines der Ausgangssignale, erreicht mindestens ein Zähler 47, 48 die Zahl 8 und bleibt da stehen, da seine Taktfrequenz von 1,1875 kHz über das MSB abgeschaltet wird. Wenn mindestens einer der beiden Zähler 47, 48 die Zahl 8 erreicht hat, liegt am Zählrichtungseingang des up/down-Zählers 52 logisch 0 und der Zähler 52 wird im 500 Hz-Takt inkrementiert. Das MSB dieses Zählers gibt als logisch 1 die Information « VRF-Signal vorhanden » und als logisch 0 « VRF-Signal nicht vorhanden ». Dieses Ausgangssignal des VRF-Detektors 27 liegt an dem einen Eingang des NOR-Gliedes 36 und sperrt als logisch 1-Signal die Multiplikation des Ausgangssignals des Addierwerkes 32 mit dem Signum des Ausgangssignals des Addierwerkes 31, so daß dei vorhandenem VRF-Signal das Einrasten der PLL auf das trägerlose AM-Signal verhindert wird.

Das Ausgangssignal des VRF-Detectors 27 ist gleichzeitig als Steuersignal einem elektronischen Umschalter 53 zugeführt, dessen Ausgang mit dem Eingang E einer Schaltungsanordnung zur Demodulation der im Modulationssignal des AM-Signals mit unterdrücktem Träger enthaltenen Phasenmodulation angeschlossen ist. Diese Schaltungsanordnung wird im folgenden als RDS- oder Phasendemolator 54 bezeichnet. Die beiden Eingänge des Umschalters 53 sind mit den beiden Ausgängen der Tiefpaßfilterschaltung 21 verbunden, und zwar zweckmäßigerweise mit jeweils dem das höchstwertige Bit führenden Teilausgang. Der Umschalter 53 wird dabei so gesteuert, daß bei vorhandenem VRF-Signal (Ausgangssignal des VRF-Detektors 27 logisch 1) der Umschalter die in Fig. 1 gezeigte Stellung einnimmt, in welcher das höchstwertige Bit des 16 Bit-Ausgangssignals des zweiten Addierwerkes 32 an dem Eingang E des Pasendemodulators 54 liegt, und zwar viermal pro 1,1875 kHz-Periode. Bei fehlendem VRF-Signal wird der Ausgang des Umschalters 53 auf den anderen Eingang umgeschaltet, so daß nunmehr in gleicher Weise das höchstwertige Bit des Ausgangssignals des ersten Addierwerkes 31 an den Phasendemodulator 54 gelangt. Auf Aufbau und Wirkungsweise des Phasendemodulators 54, der im übrigen auch im Dokument DE-A-3510562 (Veröffentlicht am 25.9.86) beschrieben ist, wird im folgenden noch eingegangen.

Die Wirkungsweise des beschriebenen Demodulators ist wie folgt :

Das nach FM-Demodulation des Empfangssignals als additiver Teil des MPX-Signals nach Bandpaßfilterung am Eingang 10 des Demodulators liegende Eingangssignal kann etwa beschrieben werden mit

$$F = A \cdot \sin(\omega t + \varphi) + R \cdot \cos(\omega t + \varphi) \tag{1}$$

mit den Modulationssignalen

$$A = a \cdot (1 + 0,6 \sin \omega_{VRF} t) \quad \text{VRF-Signal} \tag{2}$$

$$R = r \cdot \sin(\omega_{RDS} \cdot t + T \cdot \pi) \quad \text{RDS-Signal} \tag{3}$$

Des weiteren gilt

$$\omega = 2\pi \cdot 57 \text{ kHz}$$

$$\omega_{RDS} = 2\pi \cdot 1,1875 \text{ kHz}$$

$$T = 0 ; 1$$

Sind im MPX-Signal sowohl eine VRF-Kennung als auch eine RDS-Information enthalten, so nehmen A und R die vorstehend angegebenen Werte an. Fehlt die VRF-Kennung oder die RDS-Information, so sind jeweils A bzw. R Null.

Dieses Eingangssignal wird im A/D-Wandler 18 mit einer Taktfrequenz von 228 kHz in 8 Bit-Samples umgewandelt und in das Schieberegister 19 eingelesen. Die beim Auslesen aus dem Schieberegister 19 in ein 16 Bit-Wort umgewandelten Samples werden in dem Mischer 20 mit zwei um 90° zueinander phasenverschobenen 57 kHz-Rechteckimpulsfolgen multipliziert, wobei der Signalpfad in einen Sinus- and einen Kosinuspfad aufgeteilt wird. Diese Multiplikation entspricht einer Bewertung der vier 228 kHz-Samples pro 57 kHz-Periode im Sinuspfad mit $+1, +1, -1, -1$ und im Kosinuspfad mit $+1, -1, -1, +1$. In den beiden Addierwerken 31, 32 der Tiefpaßfilterschaltung 21 werden für jeden Signalpfad getrennt die Samples von insgesamt zwölf 57 kHz-Perioden, also insgesamt 48 Samples, aufaddiert. Bei dem gemäß Gl. (1) angenommenen Signal würde die Addition der Samples in einer 57 kHz-Periode ergeben für den Sinuspfad im ersten Addierwerk 31

$$S = A \sqrt{8} \cdot \cos \varphi - R \sqrt{8} \cdot \sin \varphi \qquad (4)$$

und für den Kosinuspfad im zweiten Addierwerk 32

$$C = A \sqrt{8} \cdot \sin \varphi + R \sqrt{8} \cdot \cos \varphi \qquad (5)$$

Die Ausgangsgrößen der beiden Addierwerke 31, 32 sind dann etwa zwölfmal so groß, entsprechend der Aufsummierung über zwölf 57 kHz-Perioden.

In den beiden Addierwerken 33 und 34 werden jeweils vier Ausgangsgrößen oder Ausgangssignale der Addierwerke 31, 32 addiert. Ist die PLL auf den 57 kHz-VRF-Trägereingerastet, so ist die Phasenverschiebung $\varphi$ annähernd Null. Wie sich ohne weiteres aus den Gl. (4) und (5) erkennen läßt, liegt damit am Ausgang d des dritten Addierwerkes 33 das Modulationssignal A, also das VRF-Signal, und am Ausgang d des vierten Addierwerkes 34 das mit dem Sinus des Phasenfehlers multiplizierte VRF-Signal, da durch die Integration über eine 1,1875 kHz-Periode die RDS-Komponente des Signals im Mittel Null wird. Das Ausgangssignal des Addierwerkes 34 wird als Phasenkorrektursignal dem Frequenzgenerator 11 zugeführt, wodurch kurzzeitig das Teilerverhältnis des ersten Frequenzteilers 13 geändert und dadurch der Phasenfehler $\varphi$ weiter verkleinert wird. Das RDS-Signal (R) erscheint am Ausgang des zweiten Addierwerkes 32.

Bei fehlendem VRF-Signal (A = 0) werden die vier Ausgangswerte am Ausgang des zweiten Addierwerkes 32 mit dem Signum (Vorzeichen) der Ausgangswerte am Ausgang des ersten Addierwerkes 31 in jeder 4,75 kHz-Periode multipliziert und über eine 1,1875 kHz-Periode aufaddiert. Ist die PLL auf das trägerlose AM-Signal eingerastet, so beträgt die Pasenverschiebung $\varphi \approx -90°$. Wie sich aus den Gl. (4) und (5) ableiten läßt, repräsentiert das Ausgangssignal des ersten Addierwerkes 31 das RDS-Signal (R), während am Ausgang d des dritten Addierwerkes 33 Null auftritt, da die Integration der vier Ausgangswerte des ersten Addierwerkes 31 über eine 1,1875 kHz-Periode im Mittel Null ergibt. Am Ausgang d des vierten Addierwerkes 34 tritt der mit dem Kosinus des Phasenfehlers multiplizierte Betrag des RDS- oder Modulationssignals R auf. Auch dieser wird wiederum zur Steuerung des Frequenzgenerators 11 in Richtung Verkleinerung des Phasenfehlers auf $\varphi = -90°$ zu verwendet.

Zusammenfassend ist also festzuhalten :

1. Ist in dem MPX-Signal nur das erste AM-Signal mit 57 kHz-VRF-Träger vorhanden, so rastet die PLL auf den VRF-Träger ein. Das demodulierte erste AM-Signal (Modulationssignal bzw. VRF-Signal) ist als 16 Bit-Wort am Ausgang d des dritten Addierers 33 abnehmbar.

2. Ist in dem MPX-Signal nur das zweite AM-Signal mit phasenverschobenem unterdrückten 57 kHz-Träger vorhanden, so rastet die PLL auf dieses Signal ein. Das demodulierte zweite AM-Signal (Modulationssignal oder RDS-Signal) ist als 16 Bit-Wort am Ausgang des ersten Addierwerkes 31 abnehmbar. Das Einrasten der PLL auf das trägerlose Signal wird durch die Multiplikation des Modulationssignals bzw. RDS-Signals mit dem Ausgangssignal des zweiten Addierwerkes 32 ermöglicht, das aus der multiplikativen Verknüpfung des Eingangssignals mit dem um 90° phasenverschobenen, trägerfrequenten Hilfssignal hervorgegangen ist.

3. Sind beide AM-Signale im MPX-Signal enthalten, so rastet die PLL auf den 57 kHz-VRF-Träger des ersten AM-Signals ein, da der VRF-Detektor 27 in Verbindung mit dem Multiplizierer 25 durch Unterbinden der Signummultiplikation ein Einrasten auf das trägerlose zweite AM-Signal unterbindet. In diesem Fall ist das VRF-Signal wiederum als 16 Bit-Wort am Ausgang des dritten Addierwerkes 33 abnehmbar, während das RDS-Signal als 16 Bit-Wort am Ausgang des zweiten Addierwerkes 32 ansteht.

4. In allen vorstehend genannten Fällen 1-3 erscheint am Ausgang des vierten Addierwerkes 34 ein Synchronisiersignal, das den Frequenzgenerator 11 so steuert, daß der Phasenfehler verkleinert wird und die PLL auf das jeweilige Signal einrastet.

Da — wie erwähnt-das RDS-Signal je nachdem, ob das VRF-Signal im MPX-Signal vorhanden ist oder nicht, einmal am Ausgang des zweiten Addierwerkes 32 und einmal am Ausgang des ersten Addierwerkes 31 ansteht, wird — wie beschrieben — der elektronische Umschalter 53 von dem VRF-Detektor 27 so gesteuert, daß immer das RDS-Signal am Ausgang des elektronischen Umschalters 53 erscheint und damit am Eingang E des RDS- oder Pasendemodulators 24 liegt. Dabei ist es ausreichend — wie hier —

von dem 16 Bit-Wort des RDS-Signals nur das höchstwertige Bit (MSB) dem Eingang E des Phasendemodulators 54 zuzuführen.

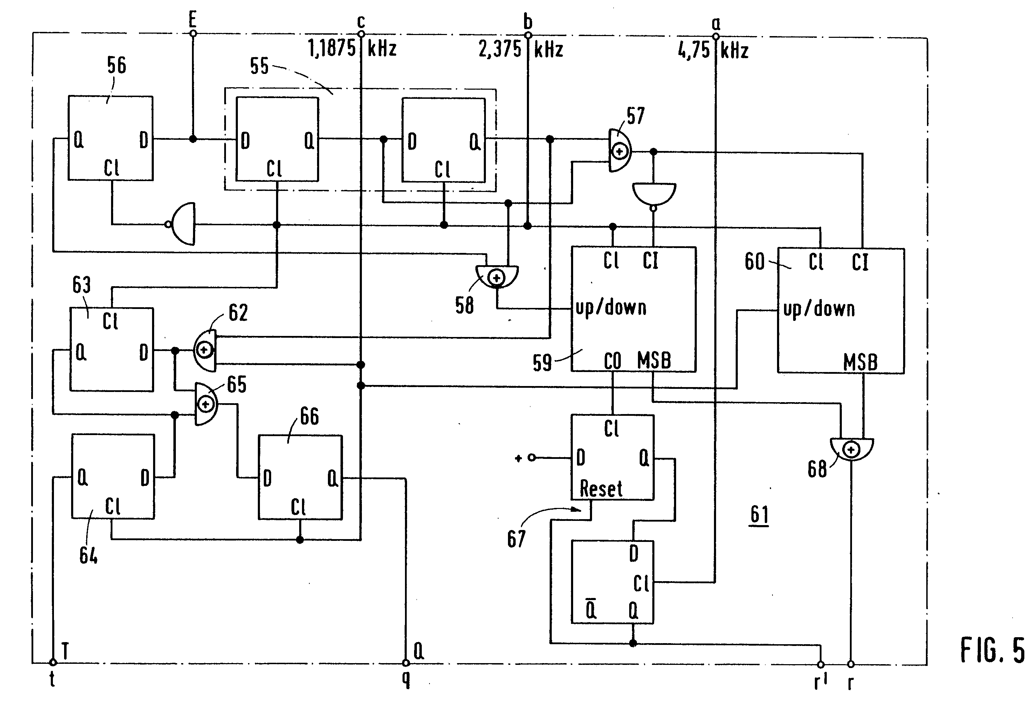

Der Phasendemodulator 54 ist in seinem Aufbau in Fig. 5 im einzelnen dargestellt. Im übrigen sei darauf verwiesen, daß Aufbau und Wirkungsweise des Phasendemodulators 54 im Dokument DE-A-3510562 ausführlich beschrieben sind, so daß hier nur der Vollständigkeit halber kurz auf den Phasendemodulator 54 eingegangen wird. Die Aufgabe des Phasendemodulators 54 ist die Rückgewinnung der im RDS-Signal enthaltenen Bitfolge, der sog. RDS-Information. Hierzu sind an dem Eingang E der Eingang eines mit der 2,375 kHz-Rechteckimpulsfolge getakteten 2 Bit-Schieberegisters 55 und der Eingang eines mit der invertierten 2,375 kHz-Rechteckimpulsfolge getakteten 1 Bit-Schieberegisters 56 angeschlossen. Die beiden parallelen Bitausgänge des 2 Bit-Schieberegisters 55 sind mit einem ersten Komparator 57 und der eine Bit-ausgang des 2 Bit-Schieberegisters 55 und der Ausgang des 1 Bit-Schieberegisters 56 mit einem Komparator 58 verbunden. Mit dem Ausgang des ersten Komparators 57 sind zwei up/down-Zähler 59, 60 in der Weise verbunden, daß ein für die Ungleichheit der Komparatoreingangssignale charakteristisches Ungleichheitssignal am Komparatorausgang dem ersten Zähler 59 und ein für die Gleichheit der Komparatoreingangssignale charakteristisches Gleichheitssignal am Komparatorausgang dem zweiten Zähler 60 zugeführt ist. Die beiden Zähler 59, 60 sind derart ausgebildet, daß das jeweilige Ausgangssignal des Komparators 57 den ersten Zähler 59 in Abhängigkeit vom Ausgangssignal des zweiten Komparators 58 und den zweiten Zähler 60 in Abhängigkeit von der momentanen Polarität der 1,1875 kHz-Rechteckimpulsfolge jeweils inkrementiert oder dekrementiert. An den Ausgängen der beiden Zähler 59, 60 ist eine Synchronisierschaltung 61 angeschlossen, deren Ausgänge den 2 Bit-Phasenkorrekturausgang r/r' des Phasendemodulators 54 bilden, der mit dem Steuereingang des dritten Frequenzteilers 15 mit steuerbarem Teilerverhältnis verbunden ist. Die Synchronisierschaltung 61 generiert aus den Ausgangssignalen der Zähler 59, 60 ein zeitbegrenztes Steuersignal zum Umschalten des Teilerverhältnisses des Frequenzteilers 15.

Ein dritter Komparator 62 ist eingangsseitig einerseits mit einem Bitausgang des 2 Bit-Schieberegisters 55 verbunden und andererseits mit der 1,1875 kHz-Rechteckimpulsfolge belegt. An dem Ausgang des dritten Komparators 62 ist die Reihenschaltung von zwei D-Flip-Flops 63, 64 angeschlossen, von denen das erste D-Flip-Flop 63 mit 2,375 kHz und das zweite D-Flip-Flop 64 mit 1,1875 kHz getaktet wird. Der D-Eingang und der Q-Ausgang des ersten D-Flip-Flops 63 sind mit einem weiteren Komparator 65 verbunden, an dessen Ausgang ein D-Flip-Flop 66 angeschlossen ist, das mit 1,1875 kHz getaktet wird. Am Q-Ausgang des D-Flip-Flops 63, also am Ausgang t des Phasendemodulators 54 ist die Bitfolge T des RDS-Information abnehmbar. Am Q-Ausgang des D-Flip-Flops 66 bzw. am Ausgang q des Phasendemodulators 54 ist eine Qualitätsaussage Q über die Richtigkeit der am D-Ausgang anstehenden Bitfolge abnehmbar. Die Komparatoren 57, 58, 62 und 65 sind hier alle als Exclusiv-Oder-Gatter ausgebildet.

Alle 4,75 kHz liegt an dem Eingang E des Phasendemodulators 54 das MSB eines 16 Bit-Wortes am Ausgang des ersten bzw. zweiten Addierwerkes 31 bzw. 32, also innerhalb einer RDS-Periode von 1,1875 kHz vier Bits. Diese Bits stellen Samples oder Abtastwerte des RDS-Signals dar und liegen jeweils um ein Viertel der RDS-Periode zueinander phasenverschoben. Dabei liegt jeder Abtastwert etwa in einer Nullstelle oder einem Extremwert des RDS-Signals. Durch die Clock der beiden Schieregister werden alle geradzahligen Abtastwerte, die den Extremwerten des RDS-Signals entsprechen, in das 2 Bit-Schieberegister 55 und alle ungeradzahligen Abtastwerte, die Nullstellen des RDS-Signals entsprechen, in das 1 Bit-Schieberegister 56 eingelesen. Die Abtastung einer Periode des RDS-Signals bildet einen Abtastzyklus. Die aufeinanderfolgenden geradzahligen Abtastwerte aller Abtastzyklen werden im Komparator 57 miteinander verglichen. Bei Ungleichheit der Vergleichswerte wird der dazwischenliegende ungeradzahlige Abtastwert im Komparator 58 mit dem in der Abtastfolge jeweils nachfolgenden oder vorausgehenden Vergleichswert auf Parität geprüft. Die Prüfergebnisse des Komparators 58 werden im Zähler 59 entsprechend ihrer Parität addiert bzw. subtrahiert, was bedeutet, daß der Zähler 59 bei jeder Clock um 1 inkrementiert bzw. dekrementiert wird. Aus der Summe wird über das MSB des Zählers 59 von der Synchronisierschaltung 61 ein Synchronisiersignal generiert, daß die Richtung einer RDS-Phasennachführung um schrittweise 1 pro 57 kHz-Periode steuert. Die Häufigkeit dieser Maßnahme wird durch den Carry-Impuls des Zählers 59 bestimmt, der den Zähler 59 jeweils um ein Viertel seines Zählbereiches zurücksetzt. Der Carry-Impuls löst in einem Torglied 67 der Synchronisierschaltung 61 einen Torimpuls von der Dauer einer 4,75 kHz-Periode aus, in welcher das Synchronisiersignal der Synchronisierschaltung 61 wirksam ist. Damit kann die PLL des Phasendemodulators 54 einrasten, allerdings um 180° unbestimmt.

Bei Gleichheit der am Komparator 57 anliegenden geradzahligen Abtastwerte wird mittels des Zählers 60 bestimmt, ob die beiden Abtastwerte aufeinanderfolgenden Abtastzyklen oder dem gleichen Abtastzyklus zugehören. Im ersten Fall liegt die Bitgrenze der RDS-Information mit dem RDS-Signal richtig, die RDS-PLL ist richtig eingerastet. Im zweiten Fall ist die RDS-PLL um 180° phasenverschoben eingerastet. In diesem Fall wird der Zähler 60 mit jedem Clock um 1 inkrementiert. Durch das MSB des Zählers 60 wird die Richtung der RDS-Phasenkorrektur über ein Exclusiv-Oder-Gatter 68 der Synchronisierschaltung 61 invertiert, so daß die Phase wegläuft, sich die stabile Lage in eine labile unwandelt und die PLL danach richtig einrasten kann.

Mittels des Komparators 62 wird zweimal pro RDS-Periode entschieden, ob die geradzahligen Abtastwerte, also die Extremwerte, mit der 1,1875 kHz-Rechteckimpulsfolge in der Polarität übereinstim-

7

men, d. h. ob der Telegramminhalt, d. h. das momentane Bit der Bitfolge der RDS-Schaltinformation logisch 0 oder logisch 1 ist. Eines dieser Ergebnisse wird am Q-Ausgang des D-Flip-Flops 64 als Bit der RDS-Schaltinformation ausgegeben. Der Vergleich beider Ergebnisse einer RDS-Periode im Komparator 65 liefert die Qualitätsaussage Q am Ausgang des D-Flip-Flops 66.

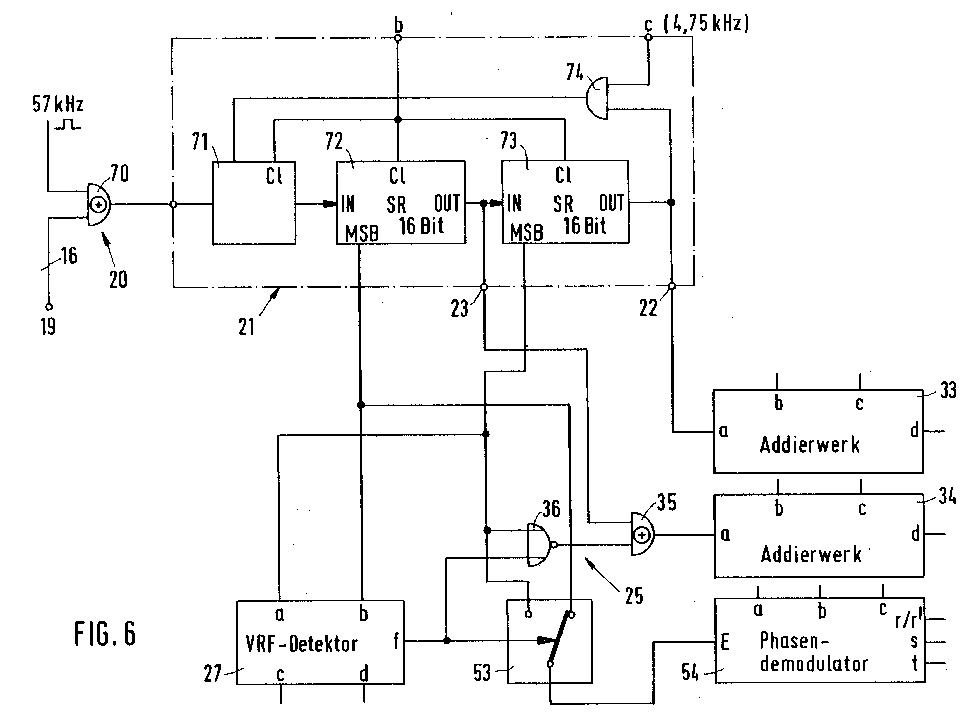

In Fig. 6 ist ein modifiziertes Ausführungsbeispiel eines Demodulators, wie er zu Fig. 1 beschrieben ist, ausschnittweise dargestellt. Dieser Demodulator unterscheidet sich von dem in Fig. 1 nur hinsichtlich des Aufbaus des Mischers 20 und der Tiefpaßfilterschaltung 21. Gleiche Bauteile sind daher mit gleichen Bezugszeichen versehen.

Bei dem Demodulator in Fig. 6 besteht der Mischer 20 aus lediglich einem EX/OR-Glied 70, an dessen einem Eingang die 57 kHz-Rechteckimpulsfolge vom Ausgang des Frequenzteilers 14 gelegt ist und dessen anderer Eingang mit dem Schieberegister 19 in Fig. 1 verbunden ist. Die dem Mischer 20 nachgeschaltete Tiefpaßfilterschaltung 21 stellt ein serielles Addierwerk mit zwei Speichern dar. Dieses serielle Addierwerk weist einen seriellen 1 Bit-Addierer 71 auf, der identisch dem 1 Bit-Addierer 40 in Fig. 4 aufgebaut ist. Am Ausgang des Addierers 71 ist ein Reihenschaltung aus zwei 16 Bit-Schieberegistern 72, 73 angeschlossen. Jeder Ausgang eines Schieberegisters bildet einen Ausgang 22, 23 der Tiefpaßfilterschaltung 21, wobei der Ausgang des unmittelbar an dem Addierer 71 angeschlossenen Schieberegisters 72 den zweiten Ausgang 23 und der Ausgang des in der Reihenschaltung letzten Schieberegisters 73 den ersten Ausgang 22 Tiefpaßfilterschaltung darstellt. Der Ausgang des in der Reihenschaltung letzten Schieberegisters 73 ist über ein AND-Glied 74 in gleicher Weise wie in Fig. 4 auf den Eingang des Addierers 71 rückgeführt. Der andere Eingang des AND-Gliedes 74 liegt an dem Eingang c, der mit dem Ausgang VII der Taktanpaßschaltung 37 verbunden ist. Die Clock-Eingänge von Addierer 71 und Schieberegister 72, 73 sind mit dem Eingang b verbunden, der seinerseits — wie in Fig. 1 — die Eingänge b der Addierwerke 31, 32 — an dem Ausgang VI der Taktanpaßschaltung 37 angeschlossen ist. Die übrigen Bauteile und ihre elektrische Verknüpfung stimmen mit Fig. 1 überein, so daß teilweise auf die Darstellung dieser Schaltungsergänzung verzichtet worden ist. Zur Klarstellung sei lediglich noch einmal hervorgehoben, daß mit dem ersten Ausgang 22 der Tiefpaßfilterschaltung 21 das Addierwerk 33 und mit dem zweiten Ausgang 23 das Addierwerk 34 verbunden ist, wobei in die letzte Verbindungsleitung der Signum-Multiplizierer 25, bestehend aus dem EX/OR-Glied 35 und dem NOR-Glied 36 eingeschaltet ist. Die MSB-Ausgänge der Schieberegister 72, 73 sind einerseits mit den Eingängen des elektronischen Umschalters 53 und andererseits mit den Eingängen des VRF-Detektors 27 verbunden. Der MSB-Ausgang des Schieberegisters 73 ist außerdem mit dem einen Eingang des NOR-Gliedes 36 verbunden, dessen anderer Eingang in bekannter Weise an dem Ausgang f des VRF-Detektors 27 liegt.

Die Funktionsweise dieses Demodulators in Fig. 6 ist die gleiche wie die des Demodulators in Fig. 1 mit folgendem Unterschied :

Die 16 Bit-Samples am Ausgang des Schieberegisters 19 werden im Mischer 20 mit dem trägerfrequenten Hilfssignal, also mit der 57 kHz-Rechteckimpulsfolge, multipliziert. Diese Multiplikation entspricht einer Bewertung der vier 228 kHz-Samples pro 57 kHz-Periode mit $+1, +1, -1, -1$. Aufgeteilt in einen Kosinus- und Sinuspfad würde dies eine Bewertung im Sinuspfad mit $0, +1, 0, -1$ und im Kosinuspfad mit $+1, 0, -1, 0$ bedeuten. In der Reihenschaltung von seriellem Addierer 71 und Schieberegister 72, 73 werden nunmehr alle geradzahligen und ungeradzahligen 16 Bit-Samples aufaddiert, wobei abwechselnd die Summe der geradzahligen Samples und die Summe der ungeradzahligen Samples in einem der beiden Schieberegister 72, 73 stehen. Nach zwölf 57 kHz-Perioden stehen damit im Schieberegister 72 die Summe aller geradzahligen Abtastwerte (Ergebnis des Kosinuspfades) und im Schieberegister 72 alle ungeradzahligen Werte (Ergebnis des Sinuspfades). Legt man wiederum das in Gl. (1) angegebene Eingangssignal mit den in Gl. (2) und (3) angegebenen Modulationssignalen zugrunde, so steht nach Addition von insgesamt vier Samples in einer 57 kHz-Periode im Schieberegister 73 das Ergebnis

$$S = 2 A \cos \varphi - 2 R \sin \varphi \qquad (6)$$

und im Schieberegister 72 das Ergebnis

$$C = 2 A \sin \varphi + 2 R \cos \varphi \qquad (7)$$

Nach zwölf 57 kHz-Perioden ist das Ergebnis etwa zwölfmal größer.

Wie ein Vergleich der Gl. (6) und (7) mit den Gl. (4) und (5) zeigt, werden bis auf eine Konstante die gleichen Ergebnisse erhalten, so daß für die weitere Funktionsweise des Demodulators nach Fig. 6 die Beschreibung der Funktionsweise des Demodulators nach Fig. 1 in gleicher Weise gilt.

Der Vorteil dieses Demodulators liegt darin, daß die beiden Speicher um 1 Bit kleiner gemacht werden können, weil weniger Bitwerte in einer 4,75 kHz-Periode (zwölf 57 kHz-Perioden) aufsummiert werden. Der Schaltungsaufwand für Mischer 20 und Tiefpaßfilterschaltung 21 wird nahezu halbiert, da sozusagen die Verarbeitung im Sinuspfad und im Kosinuspfad nicht parallel sondern alternierend erfolgt. Diese Zeitmultiplex-Nutzung der Hardware ist besonders dann interessant, wenn zur Erhöhung der Tiefpaßwirkung komplexe Rückführungen oder Filter höherer Ordnung (Kaskadierung) erforderlich werden.

Bei dem Demodulator gemäß Fig. 6 ist es auch möglich, die beiden Addierwerke 33, 34 in gleicher Weise durch ein serielles Addierwerk mit zwei Speichern zu ersetzen, wie dies für die Tiefpaßfilterschaltung 21 durchgeführt worden ist. Dabei ist jedoch sicherzustellen, daß die Multiplikation jedes zweiten Samples im Multiplizierer 25 verhindert wird.

Ein weiteres Ausführungsbeispiel des hier beschriebenen Demodulators ist in Fig. 7 im Blockschaltbild ausschnittweise dargestellt. Im Vergleich zu dem Demodulator in Fig. 1 ist hier die A/D-Wandlung und die Mischung des Eingangssignals in der Reihenfolge vertauscht. Nach einer üblichen Filterung des Eingangssignals in einem Bandpaß 80 (der auch dem Eingang 10 des Demodulators in Fig. 1 vorgeschalter sein kann) wird das analoge Eingangssignal im Mischer 81 einmal mit dem trägerfrequenten Hilfssignal und einmal mit dem un 90° phasenverschobenen trägerfrequenten Hilfssignal multipliziert. Jedes Mischprodukt am Ausgang des Mischers 81 wird getrennt verarbeitet, und zwar zunächst einem Tiefpaßfilter 82 bzw. 83, dann einem A/D-Wandler 84 bzw. 85 zugeführt, an welchen schließlich die Tiefpaßfilterschaltung 21 mit ihren beiden Eingängen angeschlossen ist. Die Tiefpaßfilterschaltung 21 besteht wie in Fig. 1 aus zwei jeweils einem Eingang zugeordneten Addierwerken 31 und 32. An den Ausgängen 22, 23 der Tiefpaßfilterschaltung 21 schließt sich dann die identische Schaltung wie in Fig. 1 an. Die A/D-Wandler 84, 85 werden ebenfalls wie in Fig. 1 von der 228 kHz-Rechteckimpulsfolge des Frequenzgenerators 11 getaktet.

Dieser Demodulator hat den Vorteil, daß Störungen, die weit außerhalb 57 kHz liegen (NF, Stereo) vor der A/D-Wandlung bereits eleminiert sind, so daß beim A/D-Wandler 84, 85 bereits eine kleinere Wortlänge von z. B. 5 oder 6 Bit, anstatt 8 Bit, ausreichend ist. Außerdem kann die Abtastfrequenz der A/D-Wandler 84, 85 wesentlich niedriger gewählt werden, z. B. 19 kHz anstatt 228 kHz.

**Patentansprüche**

1. Digitaler Demodulator zur Demodulation von Eingangssignalen, die ein einen hochfrequenten Träger enthaltendes erstes amplitudenmoduliertes Signal (AM-Signal) und/oder ein zweites amplitudenmoduliertes Signal (AM-Signal) mit unterdrücktem Träger aufweisen, wobei die beiden Träger frequenzgleich und um 90° gegeneinander phasenverschoben sind, mit einem Analog-Digital-Wandler (A/D-Wandler) (10 ; 84, 85) zum Digitalisieren des Eingangssignals, mit einem steuerbaren Frequenzgenerator (11) zum Generieren mindestens eines trägerfrequenten Hilfssignals, mit einem Mischer (20, 81), dem Eingangssignal und Hilfssignal zugeführt sind, und mit einer digitalen Tiefpaßfilterschaltung (21), deren Ausgangssignal in Sinus- und Kosinuskomponente getrennt als ein erstes und ein zweites Ausgangssignal abnehmbar ist, dadurch gekennzeichnet, daß die im Signalverlauf nach dem A/D-Wandler (10 ; 84, 85) und Mischer (20 ; 81) oder umgekehrt angeordnete digitale Tiefpaßfilterschaltung (21) eine Ausgangsdatenrate aufweist, die einem geradzahligen Vielfachen der Modulationsfrequenz (1,1875 kHz) des zweiten AM-Signals entspricht und mindestens gleich dem Vierfachen dieser Modulationsfrequenz (1,1875 kHz) und höchstens gleich der Trägerfrequenz (57 kHz) der ersten AM-Signals ist, daß jedes der beiden an der Tiefpaßfilterschaltung (21) abgenommenen Ausgangssignale einem digitalen Tiefpaß (24, 26) mit einer der Modulationsfrequenz (1,1875 kHz) des zweiten AM-Signals entsprechenden Ausgangsdatenrate zugeführt ist, daß zwischen dem das zweite Ausgangssignal führenden zweiten Ausgang (23) der Tiefpaßfilterschaltung (21) und dem zugeordneten Tiefpaß (26) ein Multiplizierer (25) eingeschaltet ist, der das zweite Ausgangssignal mit dem Signum der ersten Ausgangssignals multipliziert, daß der Ausgang (d) des mit dem zweiten Ausgangssignals belegten Tiefpasses (26) mit dem Steuereingang des Frequenzgenerators (11) verbunden ist und daß ein das Vorhandensein der ersten AM-Signals erfassender Detektor (27) vorgesehen ist, dessen für das Vorhandensein des ersten AM-Signals charakteristisches Ausgangssignal die Signummultiplikation im Multiplizierer (25) unterbindet.

2. Demodulator nach Anspruch 1, dadurch gekennzeichnet, daß am Ausgang (d) des mit dem ersten Ausgangssignal belegten Tiefpasses (24) das im ersten AM-Signal enthaltene Modulationssignal (VRF-Signal) abnehmbar ist.

3. Demodulator nach Anspruch 1 oder 2, dadurch gekennzeichnet, daß die beiden Ausgangssignale der Tiefpaßfilterschaltung (21) einem vom Detektor (27) gesteuerten Umschalter (53) zugeführt sind, an dessen Ausgang das im zweiten AM-Signal enthaltene Modulationssignal (RDS-Signal) abnehmbar ist, und daß der Umschalter (53) derart gesteuert ist, daß bei vorhandenem ersten AM-Signal der Ausgang des Umschalters (53) mit demjenigen der beiden Eingänge verbunden ist, an dem das zweite Ausgangssignal der Tiefpaßfilterschaltung (21) ansteht.

4. Demodulator nach einem der Ansprüche 1 bis 3, dadurch gekennzeichnet, daß dem Detektor (27) die Ausgangssignale der Tiefpaßfilterschaltung (21) zugeführt sind und daß der Detektor (27) derart ausgebildet ist, daß er die Ausgangssignale auf Konstanz ihrer Polarität prüft und dann ein für das Vorhandensein des ersten AM-Signals charakteristisches Ausgangssignal (logisch 1) abgibt, wenn mindestens eines der Ausgangssignale der Tiefpaßfilterschaltung (21) über eine vorgegebene Zeitdauer konstante Polarität aufweist.

5. Demodulator nach einem der Ansprüche 1 bis 4, dadurch gekennzeichnet, daß der Tiefpaßfilterschaltung (21) der Mischer (20) unmittelbar vorgeschaltet ist und beide dem A/D-Wandler (18) nachgeschaltet sind, daß die Abtastfrequenz des A/D-Wandlers (18) gleich dem Vierfachen der Trägerfrequenz (57 kHz) des ersten AM-Signals gewählt ist und daß der Frequenzgenerator (11) einen Rechteckgenerator (12) und mindestens einen Frequenzteiler (13) mit steuerbarem Teilerverhältnis aufweist, dessen Steuereingang den Steuereingang des Frequenzgenerators (11) bildet.

6. Demodulator nach Anspruch 5, dadurch gekennzeichnet, daß die beiden der Tiefpaßfilterschaltung (21) nachgeschalteten digitalen Tiefpässe (24, 26) als Addierwerke (33, 34) ausgebildet sind.

7. Demodulator nach einem der Ansprüche 5 oder 6, dadurch gekennzeichnet, daß der Mischer (20) zwei EX/OR-Glieder (28, 29) und die Tiefpaßfilterschaltung (21) zwei jeweils am Ausgang eines der EX/OR-Glieder (28, 29) angeschlossene serielle Addierwerke (31, 32) aufweist, wobei der Ausgang (d) des ersten Addierwerkes (31) den ersten Ausgang (22) und der Ausgang (d) des zweiten Addierwerkes (32) den zweiten Ausgang (23) der Tiefpaßfilterschaltung (21) bildet, daß die jeweils einen Eingänge der EX/OR-Glieder (28, 29) mit dem Ausgang eines an dem A/D-Wandler (18) angeschlossenen Schieberegisters (19) verbunden sind und daß der andere Eingang des mit dem ersten Addierwerkes (31) verbundenen EX/OR-Gliedes (28) unmittelbar und der andere Eingang des mit dem zweiten Addierwerk (32) verbundenen EX/OR-Gliedes (29) mit 90°-Phasenverschiebung an dem Ausgang des Frequenzgenerators (11) angeschlossen sind.

8. Demodulator nach einem der Ansprüche 5 oder 6, dadurch gekennzeichnet, daß der Mischer (20) ein EX/OR-Glied (70), dessen einer Eingang mit dem Ausgang eines an dem A/D-Wandler (18) angeschlossenen Schieberegisters (19) und dessen anderer Eingang mit dem Ausgang des Frequenzgenerators (11) verbunden ist, und die Tiefpaßfilterschaltung (21) ein serielles Addierwerk (71) mit zwei Speichern (72, 73) aufweist, das derart ausgebildet ist, daß in den Speichern (72, 73) abwechselnd die Summe der dem Addierwerk (71) zugeführten geradzahligen bzw. ungeradzahligen Abtastwerte (Samples) getrennt stehen und daß der Ausgang des Speichers (73), in welchem mit einer der Ausgangsdatenrate der Tiefpaßfilterschaltung (21) entsprechenden Frequenz die Summe der ungeradzahligen Abtastwerte steht, den ersten Ausgang (22) und der Ausgang des Speichers (72), in welchem mit einer der Ausgangsdatenrate der Tiefpaßfilterschaltung (21) entsprechenden Frequenz die Summe der geradzahligen Abtastwerte steht, den zweiten Ausgang (23) der Tiefpaßfilterschaltung (21) bildet.

9. Demodulator nach einem der Ansprüche 3 bis 8, dadurch gekennzeichnet, daß am Ausgang des Umschalters (53) eine Schaltungsanordnung (54) zur Demodulation der im Modulationssignal (RDS-Signal) des zweiten AM-Signals enthaltenen Phasenmodulation angeschlossen ist.

10. Demodulator nach Anspruch 9, dadurch gekennzeichnet, daß der steuerbare Frequenzgenerator (11) einen weiteren Frequenzteiler (15) mit steuerbarem Steuerverhältnis aufweist, dessen Eingang mit dem trägerfrequenten Hilfssignal belegt und dessen Steuereingang mit einem Phasenkorrekturausgang (r, r') der Schaltungsanordnung (54) verbunden ist.

## Claims

1. Digital demodulator for the demodulation of input signals which exhibit a first amplitude-modulated signal (AM signal) containing a radio-frequency carrier and/or a second amplitude-modulated signal (AM signal) with suppressed carrier, the two carriers being of the same frequency and phase shifted by 90° with respect to one another, comprising an analog/digital converter (A/D converter) (10 ; 84, 85) for digitizing the input signal, with a controllable frequency generator (11) for generating at least one carrier-frequency auxiliary signal, with a mixer (20, 81) which is supplied with the input signal and the auxiliary signal, and with a digital low-pass filter circuit (21), the output signal of which can be picked up, separated into sine and cosine components, as a first and a second output signal, characterized in that the digital low-pass filter circuit (21), which is arranged after the A/D converter (10 ; 84, 85) and mixer (20 ; 81) or conversely in the signal run, exhibits an output data rate which corresponds to an even multiple of the modulation frequency (1.1875 kHz) of the second AM signal and is at least equal to four times this modulation frequency (1.1875 kHz) and at the most equal to the carrier frequency (57 kHz) of the first AM signal, that each of the two output signals picked up at the low-pass filter circuit (21) is supplied to a digital low-pass filter (24, 26) with an output data rate corresponding to the modulation frequency (1.1875 kHz) of the second AM signal, that between the second output (23) carrying the second output signal of the low-pass filter circuit (21) and the associated low-pass filter (26), a multiplier (25) is inserted which multiplies the second output signal by the signum function of the first output signal, that the output (d) of the low-pass filter (26), to which the second output signal is applied, is connected to the control input of the frequency generator (11), and that a detector (27), which detects the existence of the first AM signal, is provided, the output signal of which, which is characteristic of the existence of the first AM signal, suppresses the signum-function multiplication in the multiplier (25).

2. Demodulator according to Claim 1, characterized in that the modulation signal (traffic programme signal) contained in the first AM signal can be picked up at the output (d) of the low-pass filter (24) to which the first output signal is applied.

3. Demodulator according to Claim 1 or 2, characterized in that both the output signals of the low-pass filter circuit (21) are supplied to a change-over switch (53) which is controlled by the detector (27) and at the output of which the modulation signal (RDS signal) contained in the second AM signal can be picked up, and that the change-over switch (53) is controlled in such a manner that when the first AM signal is present, the output of the change-over switch (53) is connected to that input of the two inputs at which the second output signal of the low-pass filter circuit (21) is present.

4. Demodulator according to one of Claims 1 to 3, characterized in that the detector (27) is supplied with the output signals of the low-pass filter circuit (21) and that the detector (27) is constructed in such a manner that it checks the output signals for the constancy of their polarity and then emits an output signal (logical 1), which is characteristic of the existence of the first AM signal, when at least one of the output signals of the low-pass filter circuit (21) exhibits a constant polarity over a predetermined period of time.

5. Demodulator according to one of Claims 1 to 4, characterized in that the low-pass filter circuit (21) is directly preceded by the mixer (20) and both follow the A/D converter (18), that the sampling frequency of the A/D converter (18) is selected to be equal to four times the carrier frequency (57 kHz) of the first AM signal, and that the frequency generator (11) exhibits a square-wave generator (12) and at least one frequency divider (13) with a controllable dividing ratio, the control input of which forms the control input of the frequency generator (11).

6. Demodulator according to Claim 5, characterized in that the two digital low-pass filters (24, 26) following the low-pass filter circuit (21) are constructed as adding units (33, 34).

7. Demodulator according to one of Claims 5 or 6, characterized in that the mixer (20) exhibits two EX/OR gates (28, 29) and the low-pass filter circuit (21) exhibits two serial adding units (31, 32) which are in each case connected to the output of one of the EX/OR gates (28, 29), the output (d) of the first adding unit (31) forming the first output (22) and the output (d) of the second adding unit (32) forming the second output (23) of the low-pass filter circuit (21), that the respective one inputs of the EX/OR gates (28, 29) are connected to the output of a shift register (19) which is connected to the A/D converter (18), and that the other input of the EX/OR gate (28) connected to the first adding unit (31) is connected directly, and the other input of the EX/OR gate (29) connected to the second adding unit (32) is connected with a 90° phase shift to the output of the frequency generator (11).

8. Demodulator according to one of Claims 5 or 6, characterized in that the mixer (20) exhibits an EX/OR gate (70) one input of which is connected to the output of a shift register (19) connected to the A/D converter (18) and the other input of which is connected to the output of the frequency generator (11), and the low-pass filter circuit (21) exhibits a serial adding unit (71) with two stores (72, 73), which is constructed in such a manner that the stores (72, 73) alternately separately contain the sum of the even and odd samples supplied to the adding unit (71) and that the output of the store (73) containing the sum of the odd samples with a frequency corresponding to the output date rata of the low-pass filter circuit (21) forms the first output (22) and the output of the store (72) containing the sum of the even samples with a frequency corresponding to the output data rate of the low-pass filter circuit (21) forms the second output (23) of the low-pass filter circuit (21).

9. Demodulator according to one of Claims 3 to 8, characterized in that a circuit arrangement (54) for demodulating the phase modulation contained in the modulation signal (RDS signal) of the second AM signal is connected to the output of the change-over switch (53).

10. Demodulator according to Claim 9, characterized in that the controllable frequency generator (11) exhibits a further frequency divider (15) with controllable control ratio, to the input of which the carrier-frequency auxiliary signal is applied and the control input of which is connected to a phase correction output (r, r') of the circuit arrangement (54).

**Revendications**

1. Démodulateur numérique pour démoduler des signaux d'entrée se composant d'une porteuse à haute fréquence contenant un premier signal modulé en amplitude (signal AM) et/ou un second signal modulé en amplitude (signal AM) à porteuse supprimée, les deux porteuses ayant la même fréquence et étant déphasées de 90°, avec un convertisseur analogique/numérique (convertisseur A/D) (10, 84, 85) pour numériser le signal d'entrée, avec un générateur de fréquence (11) commandé pour générer au moins un signal auxiliaire à la fréquence de la porteuse, avec un mélangeur (20, 81) qui reçoit le signal d'entrée et le signal auxiliaire et un filtre passe-bas numérique (21) dont le signal de sortie est séparé en une composante sinus et une composante cosinus qui sont fournies séparément comme premier signal de sortie et second signal de sortie, démodulateur caractérisé en ce que le filtre passe-bas numérique (21) placé dans le chemin du signal après le convertisseur analogique/numérique (10, 84, 85) et le mélangeur (20, 81) ou inversement présente une vitesse de sortie de données qui correspond à un multiple pair de la fréquence de modulation (1,1875 kHz) du premier signal AM et est au moins égale au multiple de cette fréquence de modulation (1,1875 kHz) et au moins égale à la fréquence de la porteuse (57 kHz) du premier signal AM, et en ce que chacun des deux signaux de sortie fournis par le filtre passe-bas (21) est appliqué à un filtre passe-bas, numérique (24, 26) avec une vitesse de sortie correspondant à la fréquence de modulation 1,1875 kHz du second signal AM, et en ce qu'entre la seconde sortie (23) du filtre passe-bas (21) qui fournit le second signal de sortie et le filtre passe-bas associé (26), il est prévu un multiplicateur (25) qui multiplie le second signal de sortie par le signe du premier signal de sortie, la sortie (d) du filtre passe-bas (26) donnant le second signal de sortie étant reliée à l'entrée de commande du générateur de fréquence (11) et en ce qu'il est prévu un détecteur (27) qui détecte la présence du premier signal AM,

11

dont le signal de sortie qui caractérise la présence du premier signal AM interdit la multiplication de signe dans le multiplicateur (25).

2. Démodulateur selon la revendication 1, caractérisé en ce que le signal de modulation (signal VRF) contenu dans le premier signal AM est fourni à la sortie (d) du filtre passe-bas (24) recevant le premier signal de sortie.

3. Démodulateur selon la revendication 1 ou 2, caractérisé en ce que les deux signaux de sortie du filtre passe-bas (21) sont appliqués à un inverseur (53) commandé par le détecteur (27), et dont la sortie fournit le signal de modulation (signal RDS) contenu dans le second signal AM, et en ce que l'inverseur (53) est commandé pour qu'en présence du premier signal AM, la sortie de l'inverseur (53) soit reliée à celle des deux entrées qui fournit le second signal de sortie du filtre passe-bas (21).

4. Démodulateur selon l'une des revendications 1 à 3, caractérisé en ce que le détecteur (27) reçoit les signaux de sortie du filtre passe-bas (21) et ce détecteur (27) est réalisé pour vérifier la constance de la polarité des signaux de sortie et pour qu'il fournisse un signal de sortie (état logique 1) caractéristique de la présence du premier signal AM, si au moins l'un des signaux de sortie du filtre passe-bas (21) présente une polarité constante pendant une durée prédéterminée.

5. Démodulateur selon l'une des revendications 1 à 4, caractérisé en ce que le filtre passe-bas (21) est directement en amont du mélangeur (20) et ses deux circuits sont en aval du convertisseur analogique/numérique (18), la fréquence de détection du convertisseur analogique/numérique (18) étant choisie égale au quadruple de la fréquence de la porteuse (57 kHz) du premier signal AM et en ce que le générateur de fréquence (11) comporte un générateur de signaux rectangulaires (12) avec au moins un diviseur de fréquence (13) à rapport de division commandé dont l'entrée de commande forme l'entrée de commande du générateur de fréquence (11).

6. Démodulateur selon la revendication 5, caractérisé en ce que les deux filtres passe-bas (24, 26), numériques en aval du filtre passe-bas (21) sont des additionneurs (33, 34).

7. Démodulateur selon l'une des revendications 5 ou 6, caractérisé en ce que le mélangeur (20) comporte deux composants EX/OR (28, 29) et le filtre passe-bas (21) comporte deux additionneurs (31, 32) en série reliés respectivement à la sortie de l'une des portes EX/OR (28, 29), la sortie (d) du premier additionneur (31) formant la première sortie (22) et la sortie (d) du second additionneur (32) formant la seconde sortie (23) du filtre passe-bas (21), et chaque fois une des entrées respectives des portes EX/OR (28, 29) est reliée à la sortie d'un registre à décalage (19) reliée au convertisseur analogique/numérique (18) et en ce que l'autre entrée de la porte EX/OR (28) reliée au premier additionneur (31) est reliée directement, l'autre entrée de la porte EX/OR (29) reliée au second additionneur (32) étant appliquée avec un déphasage de 90° à la sortie du générateur de fréquence (11).

8. Démodulateur selon l'une des revendications 5 ou 6, caractérisé en ce que le mélangeur (20) est une porteuse EX/OR (70) dont une entrée est reliée à la sortie d'un registre à décalage (19) du convertisseur A/D (18) et l'autre entrée est reliée à la sortie du générateur de fréquence (11), le filtre passe-bas (21) ayant un additionneur de type série (71) à deux mémoires (72, 73) réalisé de façon que les mémoires (72, 73) contiennent séparément et en alternance la somme des grandeurs de détection (échantillons) d'ordre pair et d'ordre impair appliquées à l'additionneur (71) et la sortie de la mémoire (73) qui contient la somme des valeurs de détection d'ordre impair à une fréquence correspondant à la vitesse de sortie du filtre passe-bas (21), forme la première sortie (22) et la sortie de la mémoire (72), qui contient la somme des valeurs de détection d'ordre pair, suivant une fréquence correspondant à la vitesse de sortie de données du filtre passe-bas (21), forme la seconde sortie (23) du filtre passe-bas (21).

9. Démodulateur selon les revendications 3 à 8, caractérisé en ce qu'à la sortie de l'inverseur (53), il est prévu un circuit (54) pour démoduler la modulation de phase contenue dans le signal de modulation (signal RDS) du second signal AM.

10. Démodulateur selon la revendication 9, caractérisé en ce que le générateur de fréquence (11), commandé, comporte un autre diviseur de fréquence (15) à rapport de division commandé dont l'entrée est occupée par le signal auxiliaire à la fréquence de la porteuse et dont l'entrée de commande est reliée à une sortie de correction de phase (r, r') du circuit (54).

FIG. 1

**Anschlüsse**

| | | |
|---|---|---|
| I | = | 4 MHz |
| II | = | 228 kHz |
| III | = | 4,75 kHz |
| IV | = | 2,375 kHz |
| V | = | 1,1875 kHz |

**Verbindungen**

| | | |
|---|---|---|
| VI | mit | 31b / 32 b |
| VII | mit | 31c / 32 c |
| VIII | mit | 33b / 34 b |
| IX | mit | 33c / 34 c |

FIG. 2

FIG. 7

FIG. 3

FIG. 4

FIG. 5

FIG. 6

57 kHz

b

c (4,75 kHz)

Addierwerk 33

Addierwerk 34

VRF-Detektor 27

Phasendemodulator 54

EP 0 200 977 B1

5